# FASCICULE DE BREVET EUROPEEN

(11) **EP 3 001 575 B1**
(45) Date de publication et mention de la délivrance du brevet: **20.02.2019**
(21) Numéro de dépôt: 15182344.0
(22) Date de dépôt: 25.08.2015
(51) Int. Cl.: H04B 5/00, G06K 7/00, G06K 7/10, G06K 19/07, H03C 1/08

(54) **PROCÉDÉ DE GESTION DU FONCTIONNEMENT D'UN OBJET CAPABLE DE COMMUNIQUER SANS CONTACT AVEC UN LECTEUR, DISPOSITIF ET OBJET CORRESPONDANTS**
VERFAHREN ZUR STEUERUNG DES BETRIEBS EINES OBJEKTS, DAS IN DER LAGE IST, OHNE EINEN KONTAKT MIT EINEM LESEGERÄT ZU KOMMUNIZIEREN, ENTSPRECHENDE VORRICHTUNG UND ENTSPRECHENDES OBJEKT
METHOD FOR MANAGING THE OPERATION OF AN OBJECT CAPABLE OF CONTACTLESS COMMUNICATION WITH A READER, CORRESPONDING DEVICE AND OBJECT

(30) Priorité: 29.09.2014 FR 1459169
(43) Date de publication de la demande: 30.03.2016
(73) Titulaire: STMicroelectronics International N.V., 1118 BH Schiphol (NL)
(72) Inventeur: DHAYNI, Achraf, 06220 VALLAURIS (FR)
(74) Mandataire: Casalonga

(56) Documents cités:
- EP-A2- 1 939 787
- EP-A2- 2 573 952
- FR-A1- 2 978 890

## Description

Des modes de mise en oeuvre et de réalisation de l'invention concernent la communication sans fil entre un lecteur et un objet, par exemple un transpondeur du type étiquette (« tag » en langue anglaise), une carte à puce sans contact ou encore un téléphone mobile émulé en mode carte sans que ces exemples ne soient limitatifs, et plus particulièrement la gestion et la correction de la modulation de charge effectuée au sein d'un tel objet, en particulier un objet NFC (« Near Field Communication »).

La communication champ proche, plus connue par l'homme du métier sous la dénomination anglosaxonne NFC (« Near Field Communication ») est une technologie de connectivité sans fil qui permet une communication sur une courte distance, par exemple 10 cm, entre des dispositifs électroniques, comme par exemple des cartes à puce sans contact ou des téléphones mobiles émulés en mode carte, et des lecteurs.

La technologie NFC est particulièrement adaptée pour connecter tout type de dispositif utilisateur et permet des communications rapides et faciles.

Un objet sans contact est un objet capable d'échanger des informations via une antenne avec un autre objet sans contact, par exemple un lecteur, selon un protocole de communication sans contact.

Un objet NFC, qui est un objet sans contact, est un objet compatible avec la technologie NFC.

La technologie NFC est une plate-forme technologique ouverte normalisée dans la norme ISO/IEC 18092 et ISO/IEC 21481 mais incorpore de nombreuses normes déjà existantes comme par exemple les protocoles type A et type B définis dans la norme ISO-14443 qui peuvent être des protocoles de communication utilisables dans la technologie NFC.

Outre sa fonction classique de téléphone, un téléphone mobile cellulaire peut être utilisé (s'il est équipé de moyens spécifiques) pour échanger des informations avec un autre dispositif sans contact, par exemple un lecteur sans contact, en utilisant un protocole de communication sans contact utilisable dans la technologie NFC.

Ceci permet d'échanger des informations entre le lecteur sans contact et des éléments sécurisés situés dans le téléphone mobile. De nombreuses applications sont ainsi possibles comme la billetterie mobile dans les transports publics (le téléphone mobile se comporte comme un ticket de transport) ou bien le paiement mobile (le téléphone mobile se comporte comme une carte de paiement).

Par ailleurs, Europay Mastercard Visa, abrégé par le sigle EMV, est un standard international de sécurité des cartes de paiement du type carte à puce initié par le consortium EMVCo. La majeure partie, voire l'intégralité des cartes bancaires à puce sont conformes au standard EMV de même que la majeure partie voire l'ensemble du parc des terminaux de paiement électroniques. Les différents livres regroupant les spécifications du standard EMV, en particulier la version 2.3 de novembre 2011, sont disponibles auprès du consortium EMVCo.

Par ailleurs, des spécifications, intitulées « EMV Contactless Specifications for Payment Systems » et comportant dans la version 2.1 de mars 2011 disponible auprès du consortium EMVCo, quatre livres, ont trait notamment au protocole de communication sans contact utilisé pour effectuer des transactions bancaires entre deux dispositifs sans contact, et conforme à la norme EMV. Le protocole de communication pour la norme EMV sans contact est ainsi principalement basé sur le protocole décrit dans la norme ISO/IEC 14443.

Lors d'une transmission d'information entre un lecteur et un objet émulé en mode étiquette ou carte, le lecteur génère un champ magnétique par l'intermédiaire de son antenne qui est généralement dans les normes classiquement utilisées, une onde sinusoïdale à 13,56MHz et ayant une amplitude comprise entre 0,5 et 7,5 ampères/mètre.

De l'autre côté, l'antenne de l'objet émulant l'étiquette module le champ généré par le lecteur.

Cette modulation est effectuée en modifiant la charge connectée aux bornes de l'antenne de l'objet.

En modifiant la charge aux bornes de l'antenne de l'objet, l'impédance de sortie de l'antenne du lecteur change en raison du couplage magnétique entre les deux antennes. Il en résulte un changement dans les amplitudes des tensions et courants présents au niveau des antennes du lecteur et de l'objet. Et, de cette façon, les informations à transmettre depuis l'objet vers le lecteur sont transmises par modulation de charge au courant d'antenne du lecteur. Une copie de ce courant est générée et injectée dans la chaîne de réception du lecteur où il est démodulé et traité de façon à extraire les informations transmises.

Cela étant, une telle modulation de charge présente certains inconvénients.

En effet, la variation de charge effectuée lors de la modulation de charge se traduit par une modulation d'amplitude et de phase du signal (tension ou courant) au niveau de l'antenne du lecteur.

Le spectre fréquentiel de ce signal comporte une raie principale, centrée par exemple à 13,56MHz, qui correspond à la porteuse (13,56MHz) et deux raies latérales correspondant au signal utile contenant les informations transmises par l'objet.

Or, il s'avère que les caractéristiques de ces raies latérales présentes au niveau de l'antenne du lecteur peuvent varier en fonction des conceptions d'antennes et de l'appariement de leur réseau, et de la position de l'objet relativement au lecteur.

Les lecteurs actuels ne contiennent qu'un démodulateur d'amplitude pour démoduler le signal (tension) aux bornes de l'antenne. De ce fait, seule l'information d'amplitude des raies latérales est détectée mais non la rotation de phase de celles-ci. Or, dans certaines situations, c'est-à-dire lorsque la modulation de phase est prépondérante par rapport à la modulation d'amplitude, la rotation des raies latérales peut être proche de plus ou moins 90° conduisant alors à des niveaux de ces raies latérales proches de 0. Et, dans ce cas, le démodulateur d'amplitude du lecteur ne peut pas détecter les signaux contenus dans ces raies dont les niveaux se situent en-dessous de son seuil de détection (seuil de sensibilité).

Il en résulte alors que de tels couples lecteur/objet ne peuvent pas satisfaire à des normes qui demandent une bonne fonctionnalité dans un certain volume de fonctionnement (« operating volume ») comme c'est le cas pour la norme EMVCO. En effet, il y a une perte de communication dans certaines positions du volume de fonctionnement défini dans ces normes.

Bien évidemment, en changeant la position de l'objet dans le volume de fonctionnement par rapport au lecteur, on peut alors augmenter le niveau de la modulation d'amplitude par rapport à celui de la modulation de phase de façon à rétablir la communication. Mais, ceci n'est pas une solution satisfaisante.

Une autre solution consisterait à incorporer dans le lecteur non seulement un démodulateur d'amplitude mais également un démodulateur de phase. Malheureusement, une telle modification n'est pas possible dans les lecteurs actuels qui contiennent seulement un démodulateur d'amplitude.

La demande de brevet EP 1939787 A2 décrit un procédé et un appareil pour améliorer la sensibilité d'un récepteur NFC en utilisant une phase de calibration pendant laquelle l'impédance de l'antenne est modifiée pour réduire le décalage de phase en fonction du niveau du signal dû à une réflexion transmis vers le signal reçu.

Selon un mode de mise en oeuvre et de réalisation, il est proposé d'ajouter dans l'objet une fonctionnalité qui garantisse que le niveau de la modulation d'amplitude du signal reçu au niveau de l'antenne du lecteur soit toujours supérieur au seuil de sensibilité du démodulateur d'amplitude du lecteur. Et, une telle solution est non seulement compatible avec les lecteurs actuels mais également avec les lecteurs futurs qui pourront incorporer en outre un démodulateur de phase.

Selon un mode de mise en oeuvre et de réalisation, il est proposé de réaliser une telle fonctionnalité de façon à être compatible avec toutes les structures d'objet et toutes les normes de communication sans fil, par exemple la technologie NFC utilisant le protocole décrit dans la norme ISO/IEC 14443 mais également les normes ISO/IEC 15693 et ISO/IEC 18000.

Selon un mode de mise en oeuvre et de réalisation, il est proposé également de réaliser cette fonctionnalité de façon particulièrement simple avec un surcoût industriellement acceptable en termes d'encombrement silicium.

Selon un aspect, il est proposé un procédé de gestion du fonctionnement d'un objet capable de communiquer sans contact avec un lecteur magnétiquement couplé audit objet, comprenant au moins une phase de transmission d'information depuis ledit objet vers le lecteur comportant une modulation de l'impédance d'une charge connectée aux bornes de l'antenne dudit objet.

Selon une caractéristique générale de cet aspect, le procédé comprend en outre, préalablement à ladite au moins une phase de transmission, une phase de contrôle comportant un contrôle du niveau de modulation d'amplitude d'un signal de test modulé présent à l'antenne de l'objet et résultant d'une modulation de test de l'impédance de ladite charge, et une modification capacitive de l'impédance de ladite charge si ce niveau est inférieur à un seuil.

Cette modification capacitive comporte avantageusement une adjonction capacitive à ladite charge.

Ledit seuil correspond avantageusement à un seuil de sensibilité d'un démodulateur d'amplitude du lecteur.

Ainsi, si le niveau de modulation d'amplitude du signal de test modulé présent à l'antenne de l'objet est supérieur audit seuil, cela signifie que le niveau de modulation du signal présent au niveau de l'antenne du lecteur est au-dessus du seuil de sensibilité du démodulateur d'amplitude. Il n'y a donc pas lieu alors de modifier l'impédance de la charge connectée aux bornes de l'antenne de l'objet.

Par contre, dans le cas contraire, cela signifie que le niveau de modulation du signal reçu par l'antenne du lecteur se situe en-dessous du seuil de sensibilité du démodulateur du lecteur et que la majeure partie de l'énergie de modulation de charge a été translatée en une modulation de phase au lieu d'une modulation d'amplitude. Et, dans ce cas, la modification capacitive de l'impédance de ladite charge qui se traduit par exemple par une connexion d'au moins un condensateur aux bornes de l'antenne de l'objet, permet d'injecter « idéalement » une rotation de phase de 90° aux raies latérales de façon à rendre prépondérant l'amplitude de modulation par rapport à l'amplitude de phase et par conséquent augmenter les niveaux des raies latérales de telle sorte que la modulation d'amplitude du signal reçu par l'antenne du lecteur puisse être démodulée par le démodulateur d'amplitude du lecteur.

Une façon particulièrement simple d'effectuer le contrôle du niveau de modulation de l'amplitude du signal de test modulé peut comprendre une détermination de l'enveloppe de ce signal de test, une détermination de l'amplitude entre les pics et les creux de cette enveloppe et une comparaison de cette amplitude audit seuil.

Selon un mode de mise en oeuvre, ladite modulation de test comprend une génération d'un signal de modulation de test, par exemple une succession d'états logiques bas et haut, configuré pour modifier successivement ladite impédance de façon à ce qu'elle prenne alternativement deux valeurs différentes.

En pratique, ladite charge peut comprendre une première résistance connectée en parallèle aux bornes de ladite antenne, une deuxième résistance connectée en parallèle aux bornes de ladite antenne par l'intermédiaire d'un interrupteur commandé par le signal de modulation de test, le signal de modulation de test prenant successivement et alternativement un niveau bas et un niveau haut de façon à successivement et alternativement électriquement connecter ou non la deuxième résistance aux bornes de l'antenne.

Le procédé peut comporter plusieurs phases successives de transmission d'information entre l'objet et le lecteur. Si après la première phase de transmission la position de l'objet par rapport au lecteur ne varie pas, il serait en théorie inutile de procéder à une nouvelle phase de contrôle préalablement à toute nouvelle phase de transmission d'informations. Mais, en pratique, il est préférable, lorsqu'il est prévu plusieurs phases de transmission d'informations, d'effectuer une phase de contrôle préalablement à chaque phase de transmission.

Selon un autre aspect, il est proposé un dispositif de gestion du fonctionnement d'un objet capable de communiquer sans contact avec un lecteur magnétiquement couplé audit objet, comprenant des premiers moyens configurés pour effectuer une modulation de l'impédance d'une charge connectée aux bornes de l'antenne lors d'une phase de transmission d'informations depuis ledit objet vers le lecteur.

Selon une caractéristique générale de cet autre aspect, le dispositif comprend en outre des moyens de contrôle configurés pour effectuer, préalablement à ladite phase de transmission, une phase de contrôle comportant une modulation de test de l'impédance de ladite charge, un contrôle du niveau de modulation d'amplitude d'un signal de test modulé présent à l'antenne de l'objet et résultant de ladite modulation de test et une modification capacitive de l'impédance de ladite charge si ce niveau est inférieur à un seuil.

Selon un mode de réalisation, les moyens de contrôle comprennent des moyens de traitement configurés pour déterminer l'enveloppe de ce signal de test et l'amplitude entre les pics et les creux de cette enveloppe et des moyens de comparaison configurés pour effectuer une comparaison de cette amplitude audit seuil.

Selon un mode de réalisation, les moyens de contrôle comprennent des moyens de test configurés pour effectuer ladite modulation de test et comportant un générateur d'un signal de modulation de test apte à modifier successivement ladite impédance de façon à celle prenne alternativement deux valeurs différentes.

Selon un mode de réalisation, ladite charge comprend une première résistance connectée en parallèle aux bornes de ladite antenne, et les moyens de test comprennent une deuxième résistance connectée en parallèle aux bornes de ladite antenne par l'intermédiaire d'un interrupteur commandé par le signal de modulation de test, le signal de modulation de test prenant successivement et alternativement un niveau bas et un niveau haut de façon à successivement et alternativement électriquement connecter ou non ladite deuxième résistance aux bornes de l'antenne.

Selon un mode de réalisation, les moyens de contrôle comprennent un condensateur connecté aux bornes de ladite antenne par l'intermédiaire d'un interrupteur auxiliaire commandé par le signal de sortie des moyens de comparaison.

Le dispositif tel que défini ci-avant peut être avantageusement réalisé de façon intégrée.

Selon un autre aspect, il est proposé un objet, par exemple une carte à puce, une étiquette, un téléphone mobile cellulaire pouvant être émulé en mode carte, incorporant un dispositif tel que défini ci-avant.

D'autres avantages et caractéristiques de l'invention apparaîtront à l'examen de la description détaillée de modes de mise en oeuvre et de réalisation, nullement limitatifs, et des dessins annexés sur lesquels :

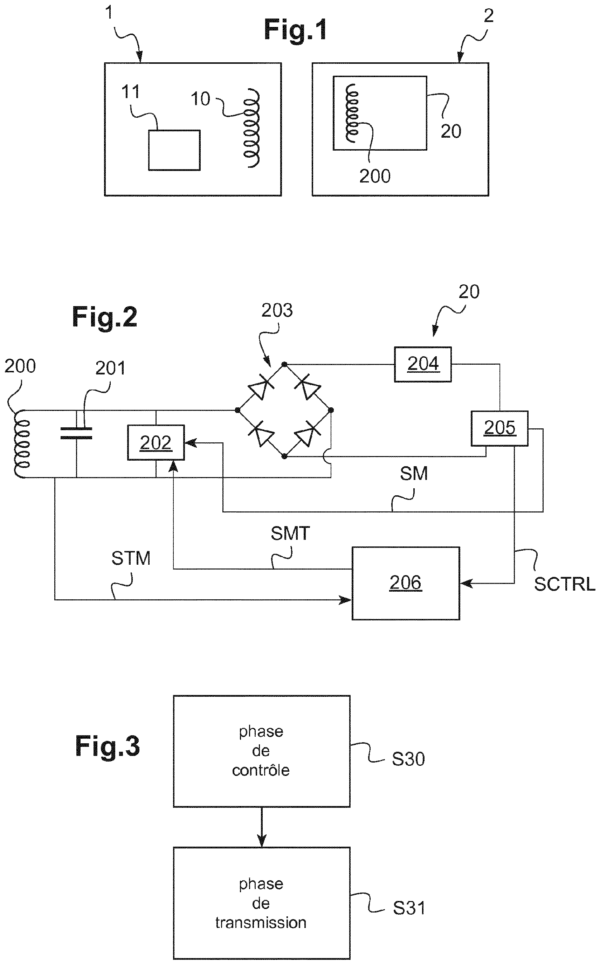

- Les figures 1 à 7 illustrent schématiquement des modes de mise en oeuvre et de réalisation de l'invention.

Sur la figure 1, la référence 1 désigne un lecteur, par exemple mais non limitativement un téléphone mobile cellulaire émulé en mode lecteur ou bien un lecteur classique de carte à puce sans contact ou d'étiquette (Tag) tel qu'un badge, comportant une antenne 10 ainsi qu'un démodulateur d'amplitude 11 configuré pour effectuer une démodulation d'amplitude d'un signal susceptible d'être modulé en amplitude et reçu au niveau de l'antenne 10, par exemple la tension aux bornes de cette antenne.

La référence 2 désigne un objet, par exemple un téléphone mobile cellulaire émulé en mode carte, et plus généralement un transpondeur électromagnétique (Tag) telle qu'une étiquette ou un badge.

Cet objet 2 comporte ici un circuit intégré 20 possédant également une antenne 200 magnétiquement couplée au lecteur 1 par un champ magnétique irradié par le lecteur 1.

Sur la figure 2, on voit que le circuit intégré comporte avec la bobine 200 un condensateur 201 formant avec cette bobine un circuit résonant parallèle pour moduler le champ magnétique généré par un circuit oscillant du lecteur. Ce circuit résonant 200-201 est connecté aux deux entrées alternatives d'un pont redresseur à diodes 203. En variante, il serait possible d'utiliser comme élément de redressement un élément de redressement mono-alternance.

Quand le transpondeur entre dans le champ magnétique du lecteur, une tension haute-fréquence est générée aux bornes du circuit résonant 200-201. Cette tension redressée par le pont redresseur 203, fournit une tension d'alimentation au circuit électronique 205 du transpondeur, par l'intermédiaire d'un régulateur de tension 204. Le circuit électronique 205, intégrant le plus souvent le régulateur 204, peut contenir au moins une mémoire et un processeur.

Pour permettre la transmission de données depuis le transpondeur vers le lecteur 1, le circuit 205 commande un étage 202 de rétro-modulation du circuit résonant 200-201. Cet étage 202 comporte au moins un commutateur électronique, commandé par un signal SM délivré par le circuit 205 et au moins une résistance de façon à modifier la charge connectée aux bornes de l'antenne 200 et permettre la détection côté lecteur.

Le circuit intégré 20 comporte également des moyens de contrôle 206 commandables par un signal de commande SCTRL délivré par le circuit 205. Ces moyens de contrôle 206 sont configurés pour effectuer, préalablement à une phase de transmission de données, une phase de contrôle comportant
une modulation de test de l'impédance de la charge connectée aux bornes de l'antenne,
un contrôle du niveau de modulation d'amplitude d'un signal de test modulé STM présent à l'antenne de l'objet et résultant de ladite modulation de test et une modification capacitive de l'impédance de la charge si ce niveau est inférieur à un seuil.

A cet égard, comme on le verra plus en détail ci-après, les moyens de contrôle 206 génèrent un signal de modulation de test SMT.

Comme illustré sur la figure 3, la phase de contrôle S30 est effectuée jusqu'avant la phase de transmise S31 des données comportant la modulation de charge. En pratique, s'il existe plusieurs phases de transmission successives, une phase de contrôle S30 sera effectuée avant chaque phase de transmission S31.

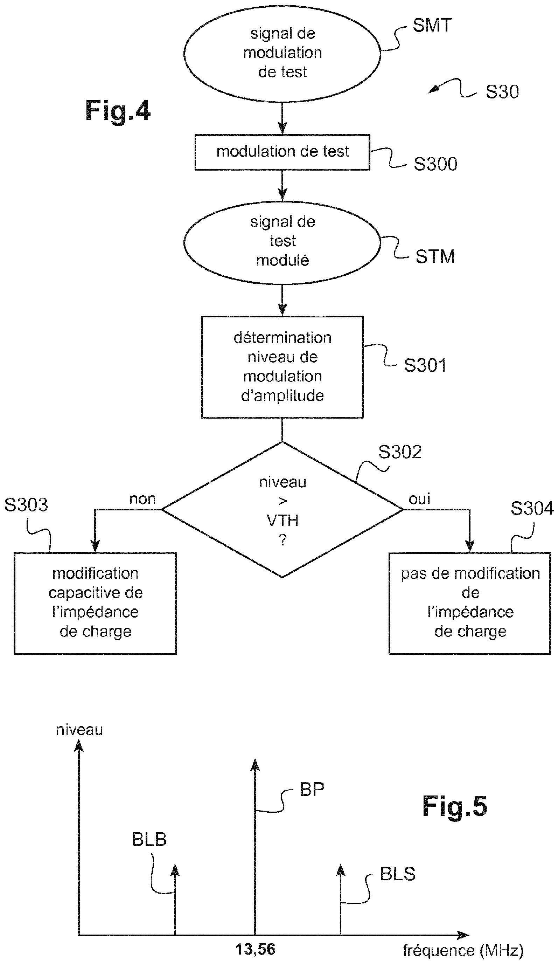

Comme illustré sur la figure 4, la phase de contrôle S30 comporte une modulation de test S300 effectuée sur la charge connectée aux bornes de l'antenne 200 en utilisant le signal de modulation de test SMT de façon à obtenir au niveau de l'antenne 200 un signal de test modulé STM, par exemple la tension aux bornes de la bobine 200.

On détermine ensuite (étape S301) le niveau de modulation d'amplitude du signal de test modulé STM.

Puis, on compare, dans une étape S302, ce niveau à un seuil VTH choisi en fonction du seuil de sensibilité du démodulateur 11 du lecteur.

On rappelle ici, comme illustré schématiquement sur la figure 5 qui illustre schématiquement le spectre fréquentiel du signal (tension) aux bornes de l'antenne du lecteur, que le signal utile contenant les informations transmises est situé dans les raies latérales BLB et BLS fréquentiellement décalées de la raie centrale BP centrée sur la fréquence porteuse, par exemple 13,56MHz.

Si le niveau du signal de test modulé est supérieur au seuil VTH, alors cela signifie qu'il y a suffisamment de modulation d'amplitude au niveau de l'antenne 200 de l'objet et par conséquent suffisamment de modulation d'amplitude au niveau du signal reçu par l'antenne 10 du lecteur ce qui va permettre au démodulateur 11 du lecteur de pouvoir correctement démoduler le signal pour détecter les informations.

Si le niveau de modulation d'amplitude du signal de test modulé STM est inférieur au seuil VTH, cela signifie alors que l'amplitude de phase du signal présent à l'antenne 200 de l'objet est prépondérante par rapport à la modulation d'amplitude, ce qui va se traduire par un niveau de modulation d'amplitude du signal présent à l'antenne 10 du lecteur insuffisant pour permettre une démodulation du signal et par conséquent une détection des informations transmises.

Dans ce cas, on effectue (étape S303) une modification capacitive de l'impédance de charge de façon à appliquer (idéalement) une rotation de phase de 90° aux raies latérales fréquentielles BLB et BLS du signal reçu par l'antenne 10 de l'objet.

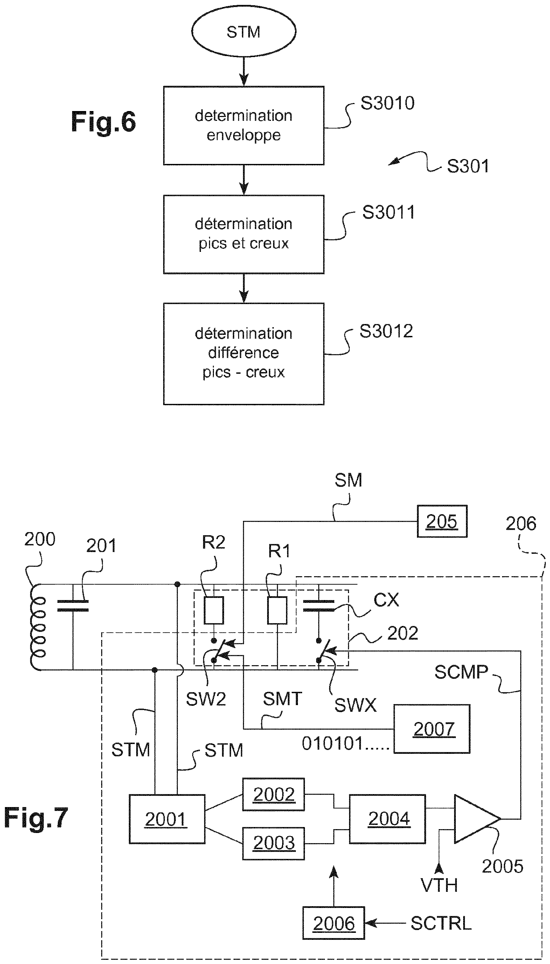

En pratique, comme illustré sur la figure 6, la détermination du niveau d'amplitude du signal de test modulé STM peut comprendre une détermination S3010 de l'enveloppe du signal STM puis une détermination S3011 des pics et creux de cette enveloppe et enfin une détermination de la différence entre les pics et les creux (étape S3012). Cette différence est représentative du niveau de modulation d'amplitude du signal de test modulé STM.

Matériellement, les moyens de contrôle 206 comportent, comme illustré schématiquement sur la figure 7, des moyens de traitement comportant un bloc 2001 configuré pour déterminer l'enveloppe du signal de test modulé STM, ici l'enveloppe de la tension aux bornes du circuit résonant 200-201, un bloc 2002 configuré pour déterminer les pics de cette enveloppe et un bloc 2003 configuré pour déterminer les creux de cette enveloppe.

Les moyens de traitement comportent également en sortie des blocs 2002 et 2003 un bloc 2004 configuré pour effectuer la différence entre le niveau des pics et le niveau des creux de façon à déterminer l'amplitude entre les pics et les creux de cette enveloppe. Les blocs 2001 2002 2003 et 2004 sont des blocs connus en soi et de structure classique.

La sortie du bloc 2004 est donc représentative du niveau de modulation d'amplitude du signal STM.

Les moyens de contrôle 206 comportent par ailleurs un comparateur 2005 pour comparer ce niveau au seuil VTH de façon à délivrer un signal de comparaison SCMP qui peut prendre un état logique haut ou un état logique bas en fonction de la comparaison.

Les moyens de rétro-modulation 202 comporte par ailleurs dans cet exemple de réalisation, une première résistance R1 connectée aux bornes du circuit résonant 200-201 et une deuxième résistance R2 connectée aux bornes du circuit résonant par l'intermédiaire d'un interrupteur SW2.

Dans une phase de transmission, cet interrupteur SW2 est commandé par le signal de modulation SM délivré par le processeur 205 de façon à pouvoir transmettre les données vers le lecteur.

Par contre, dans la phase de contrôle, cet interrupteur SW2 est commandé par le signal de modulation de test SMT délivré par un générateur 2007 et comportant ici une succession de « 0 » et de « 1 » logiques de façon à successivement et alternativement ouvrir et fermer l'interrupteur SW2.

Les moyens de rétro-modulation 202 comportent par ailleurs au moins un condensateur CX connecté aux bornes de l'antenne 200 par l'intermédiaire d'un interrupteur SWX commandé par le signal de comparaison SCMP.

Plus précisément, si le signal de comparaison SCMP est égal à 0, l'interrupteur SWX est ouvert et le condensateur CX n'est pas électriquement connecté aux bornes de l'antenne.

Si le signal SCMP est à l'état logique « 1 », l'interrupteur SWX est alors fermé connectant électriquement le condensateur CX aux bornes de l'antenne 200.

Si le niveau de modulation d'amplitude du signal STM est supérieur au seuil VTH, alors le signal SCMP prend l'état logique « 0 » tandis que si le niveau de modulation d'amplitude du signal STM est inférieur au seuil VTH, le signal SCMP prend l'état logique « 1 ».

Les moyens de contrôle 206 comportent également un bloc de commande 2006 recevant le signal de commande SCTRL émanant du processeur 205 et capable d'activer sur commande l'ensemble des éléments des moyens de contrôle 206 de façon à effectivement déclencher la phase de contrôle avant la phase de transmission de données.

La valeur du seuil VTH et la valeur du condensateur CX peuvent être déterminés par simulation.

Plus précisément la valeur du seuil VTH est liée à la norme de transmission utilisée.

On suppose par exemple que la transmission doit satisfaire à la norme EMVCo.

Selon cette norme, au niveau d'une sonde du lecteur dénommée J2 et à une certaine position de l'objet (carte par exemple) par rapport au lecteur, le lecteur doit recevoir un niveau minimum Vpp de signal résultant de la modulation de charge.

L'homme du métier pourra par exemple se référer à toutes fins utiles à la page 32 notamment du livre intitulé EMVContactless Specifications for Payment Systems, EMV Contactless Communication Protocol Spécification, version 2.0.1, juillet 2009, qui montre une figure illustrant le signal J2 du lecteur avec la définition de Vpp, ainsi qu'à la table A3 (page 134) de ce même livre pour trouver les différentes valeurs de Vpp pour différentes positions (z, r) de la carte.

Et par simulation, l'homme du métier pourra déterminer la valeur du seuil VTH qui garantit que le signal reçu par le lecteur a un niveau supérieur à Vpp.

Quant à la valeur capacitive du condensateur CX, elle dépend du schéma du circuit de l'objet. Et par simulation l'homme du métier pourra déterminer la valeur capacitive de CX nécessaire pour faire tourner la phase des bandes latérales d'environ 90°. La phase de ces bandes latérales peut être par exemple déterminée par simulation en trouvant la transformée de Fourier du signal J2.

En d'autres termes, la valeur de VTH et la valeur capacitive de CX peuvent être évaluées en simulant le circuit de l'objet couplé au lecteur. Et les difficultés de détection de l'objet surviennent toujours lorsque l'objet est éloigné du lecteur. Aussi on déterminera la valeur de VTH et la valeur capacitive de CX à des positions limites de l'objet (par exemple pour z supérieur à 2 et r égal à 2,5 dans la table A3 précitée). On obtient alors différentes valeurs simulées pour VTH et CX et on peut choisir alors par exemple la moyenne de ces valeurs comme valeurs effectivement implémentées pour VTH et CX.

## Revendications

1. Procédé de gestion du fonctionnement d'un objet capable de communiquer sans contact avec un lecteur magnétiquement couplé audit objet, comprenant au moins une phase de transmission d'informations depuis ledit objet vers le lecteur comportant une modulation de l'impédance d'une charge connectée aux bornes de l'antenne dudit objet, **caractérisé en ce qu'**il comprend en outre préalablement à ladite au moins une phase de transmission (S31), une phase de contrôle (S30) comportant un contrôle (S301) du niveau de modulation d'amplitude d'un signal de test modulé (STM) présent à l'antenne de l'objet et résultant d'une modulation de test (S300) de l'impédance de ladite charge et une modification capacitive de l'impédance de ladite charge si ce niveau est inférieur à un seuil (VTH), le seuil (VTH) étant choisi compte tenu d'un seuil de sensibilité d'un démodulateur d'amplitude (11) du lecteur.

2. Procédé selon la revendication 1, dans lequel ledit contrôle du niveau de modulation d'amplitude du signal de test modulé comprend une détermination (S3010) de l'enveloppe de ce signal de test, une détermination (S3011, S3012) de l'amplitude entre les pics et les creux de cette enveloppe et une comparaison de cette amplitude audit seuil.

3. Procédé selon l'une des revendications précédentes, dans lequel ladite modulation de test comprend une génération d'un signal de modulation de test (SM1) configuré pour modifier successivement ladite impédance de façon à celle prenne alternativement deux valeurs différentes.

4. Procédé selon la revendication 3, dans lequel ladite charge comprend une première résistance (R1) connectée en parallèle aux bornes de ladite antenne, une deuxième résistance (R2) connectée en parallèle aux bornes de ladite antenne par l'intermédiaire d'un interrupteur (SW2) commandé par le signal de modulation de test, le signal de modulation de test (SMT) prenant successivement et alternativement un niveau bas et un niveau haut de façon à successivement et alternativement électriquement connecter ou non ladite deuxième résistance aux bornes de l'antenne.

5. Procédé selon l'une des revendications précédentes, dans lequel la modification capacitive de l'impédance de ladite charge comprend une connexion d'un condensateur (CX) aux bornes de ladite antenne.

6. Procédé selon l'une des revendications précédentes, comprenant plusieurs phases de transmission d'informations et une phase de contrôle préalablement à chaque phase de transmission.

7. Dispositif de gestion du fonctionnement d'un objet capable de communiquer sans contact avec un lecteur magnétiquement couplé audit objet, comprenant des premiers moyens (205, 203) configurés pour effectuer une modulation de l'impédance d'une charge connectée aux bornes de l'antenne lors d'une phase de transmission d'informations depuis ledit objet vers le lecteur, **caractérisé en ce qu'**il comprend en outre des moyens de contrôle (206) configurés pour effectuer, préalablement à ladite phase de transmission, une phase de contrôle comportant une modulation de test de l'impédance de ladite charge, un contrôle du niveau de modulation d'amplitude d'un signal de test modulé présent à l'antenne de l'objet et résultant de ladite modulation de test et une modification capacitive de l'impédance de ladite charge si ce niveau est inférieur à un seuil (VTH) correspondant à un seuil de sensibilité d'un démodulateur d'amplitude du lecteur.

8. Dispositif selon la revendication 7, dans lequel les moyens de contrôle (206) comprennent des moyens de traitement (2001-2004) configurés pour déterminer l'enveloppe de ce signal de test et l'amplitude entre les pics et les creux de cette enveloppe et des moyens de comparaison (2005) configurés pour effectuer une comparaison de cette amplitude audit seuil.

9. Dispositif selon l'une des revendications 7 ou 8, dans lequel les moyens de contrôle (2003) comprennent des moyens de test configurés pour effectuer ladite modulation de test et comportant un générateur (2007) d'un signal de modulation de test (SMT) apte à modifier successivement ladite impédance de façon à celle prenne alternativement deux valeurs différentes.

10. Dispositif selon la revendication 9, dans lequel ladite charge comprend une première résistance (R1) connectée en parallèle aux bornes de ladite antenne, et les moyens de test comprennent une deuxième résistance (R2) connectée en parallèle aux bornes de ladite antenne par l'intermédiaire d'un interrupteur (SW2) commandé par le signal de modulation de test (SMT), le signal de modulation de test prenant successivement et alternativement un niveau bas et un niveau haut de façon à successivement et alternativement électriquement connecter ou non ladite deuxième résistance aux bornes de l'antenne.

11. Dispositif selon l'une des revendications 7 à 10, dans lequel les moyens de contrôle (206) comprennent un condensateur (CX) connecté aux bornes de ladite antenne par l'intermédiaire d'un interrupteur auxiliaire (SWX) commandé par le signal de sortie (SCM2) des moyens de comparaison (2005).

12. Dispositif selon l'une des revendications 7 à 11, réalisé de façon intégrée.

13. Objet comprenant un dispositif selon l'une des revendications 7 à 12.

## Patentansprüche

1. Verfahren zum Management der Funktion eines Objekts ausgebildet zum kontaktlosen Kommunizieren mit einem mit dem Objekt magnetisch gekoppelten Lesegerät, umfassend wenigstens eine Phase der Übertragung von Informationen vom Objekt zum Lesegerät umfassend eine Modulation der Impedanz einer an den Klemmen der Antenne des Objekts angeschlossenen Last, **dadurch gekennzeichnet, dass** es ferner vor der wenigstens einen Übertragungsphase (S31) eine Kontrollphase (S30) umfassend eine Kontrolle (S301) des Amplitudenmodulationspegels eines an der Antenne des Objekts anliegenden modulierten Testsignals (STM) und resultierend aus einer Testmodulation (S300) der Impedanz der Last und einer kapazitiven Änderung der Impedanz der Last, wenn dieser Pegel unter einer Schwelle (VTH) liegt, umfasst, wobei die Schwelle (VTH) unter Berücksichtigung einer Empfindlichkeitsschwelle eines Amplitudendemodulators (11) des Lesegeräts gewählt wird.

2. Verfahren nach Anspruch 1, wobei die Kontrolle des Amplitudenmodulationspegels des modulierten Testsignals ein Ermitteln (S3010) der Umhüllenden dieses Testsignals, ein Ermitteln (S3011, S3012) der Amplitude zwischen Höhen und Tiefen dieser Umhüllenden und ein Vergleichen dieser Amplitude mit der Schwelle umfasst.

3. Verfahren nach einem der vorhergehenden Ansprüche, wobei die Testmodulation ein Erzeugen eines zum schrittweisen Ändern der Impedanz, so dass diese alternativ zwei verschiedene Werte aufweist, ausgebildeten Testmodulationssignals (SM1) umfasst.

4. Verfahren nach Anspruch 3, wobei die Last einen parallel an den Klemmen der Antenne angeschlossenen ersten Widerstand (R1) und einen parallel an den Klemmen der Antenne über einen vom Testmodulationssignal gesteuerten Schalter (SW2) angeschlossenen zweiten Widerstand (R2) umfasst, wobei das Testmodulationssignal (SMT) nacheinander und alternativ einen niedrigen Pegel und einen hohen Pegel aufweist, so dass nacheinander und alternativ der zweite Widerstand mit den Klemmen der Antenne elektrisch verbunden ist oder nicht.

5. Verfahren nach einem der vorhergehenden Ansprüche, wobei die kapazitive Änderung der Impedanz der Last einen Anschluss eines Kondensators (CX) an den Klemmen der Antenne umfasst.

6. Verfahren nach einem der vorhergehenden Ansprüche, umfassend mehrere Informationsübertragungsphasen und eine Kontrollphase vor jeder Übertragungsphase.

7. Vorrichtung zum Management der Funktion eines Objekts ausgebildet zum kontaktlosen Kommunizieren mit einem mit dem Objekt magnetisch gekoppelten Lesegerät, umfassend zum Ausführen einer Impedanzmodulation einer an den Klemmen der Antenne angeschlossenen Last in einer Phase des Übertragens von Informationen vom Objekt zum Lesegerät ausgebildete erste Mittel (205, 203), **dadurch gekennzeichnet, dass** sie ferner zum Ausführen, vor der Übertragungsphase, einer Kontrollphase umfassend eine Testmodulation der Impedanz der Last, eine Kontrolle des Amplitudenmodulationspegels eines an der Antenne des Objekts anliegenden modulierten und aus der Testmodulation resultierenden Testsignals und eine kapazitive Änderung der Impedanz der Last, wenn dieser Pegel unter einer Schwelle (VTH) entsprechend einer Empfindlichkeitsschwelle eines Amplitudendemodulators des Lesegeräts liegt, ausgebildete Kontrollmittel (206) umfasst.

8. Vorrichtung nach Anspruch 7, wobei die Kontrollmittel (206) zum Ermitteln der Umhüllenden dieses Testsignals und der Amplitude zwischen den Höhen und Tiefen dieser Umhüllenden ausgebildete Verarbeitungsmittel (2001-2004) und zum Durchführen eines Vergleichs dieser Amplitude mit der Schwelle ausgebildete Vergleichsmittel (2005) umfassen.

9. Vorrichtung nach Anspruch 7 oder 8, wobei die Kontrollmittel (2003) zum Durchführen der Testmodulation ausgebildete und einen Erzeuger (2007) eines zum schrittweisen Ändern der Impedanz, so dass diese alternativ zwei verschiedene Werte aufweist, ausgebildeten Testmodulationssignals (SMT) umfassende Testmittel umfassen.

10. Vorrichtung nach Anspruch 9, wobei die Last einen parallel an den Klemmen der Antenne angeschlossenen ersten Widerstand (R1) umfasst und die Testmittel einen parallel an den Klemmen der Antenne über einen vom Testmodulationssignal (SMT) gesteuerten Schalter (SW2) angeschlossenen zweiten Widerstand (R2) umfassen, wobei das Testmodulationssignal nacheinander und alternativ einen niedrigen Pegel und einen hohen Pegel aufweist, so dass nacheinander und alternativ der zweite Widerstand mit den Klemmen der Antenne elektrisch verbunden ist oder nicht.

11. Vorrichtung nach einem der Ansprüche 7 bis 10, wobei die Kontrollmittel (206) einen an den Klemmen der Antenne über einen vom Ausgangssignal (SCM2) der Vergleichsmittel (2005) gesteuerten Hilfsschalter (SWX) angeschlossenen Kondensator (CX) umfassen.

12. Vorrichtung nach einem der Ansprüche 7 bis 11 in integrierter Ausführung.

13. Objekt umfassend eine Vorrichtung nach einem der Ansprüche 7 bis 12.

## Claims

1. Method for managing the operation of an object capable of contactless communication with a reader magnetically coupled to the said object, comprising at least one transmission phase of information from the said object to the reader comprising a modulation of the impedance of a load connected to the terminals of the antenna of the said object, **characterized in that** it furthermore comprises, prior to the said at least one transmission phase (S31), a monitoring phase (S30) comprising a monitoring (S301) of the level of amplitude modulation of a modulated test signal (STM) present at the antenna of the object and resulting from a test modulation (S300) of the impedance of the said load and a capacitive modification of the impedance of the said load if this level is lower than a threshold (VTH), the threshold (VTH) being chosen taking into account a sensitivity threshold of an amplitude demodulator (11) of the reader.

2. Method according to Claim 1, in which the said monitoring of the level of amplitude modulation of the modulated test signal comprises a determination (S3010) of the envelope of this test signal, a determination (S3011, S3012) of the amplitude between the peaks and the troughs of this envelope and a comparison of this amplitude with the said threshold.

3. Method according to one of the preceding claims, in which the said test modulation comprises the generation of a test modulation signal (SM1) configured for successively modifying the said impedance in such a manner that it alternately takes two different values.

4. Method according to Claim 3, in which the said load comprises a first resistor (R1) connected in parallel across the terminals of the said antenna, a second resistor (R2) connected in parallel across the terminals of the said antenna via a switch (SW2) controlled by the test modulation signal, the test modulation signal (SMT) successively and alternately taking a low level and a high level so as to successively and alternately electrically connect, or otherwise, the said second resistor to the terminals of the antenna.

5. Method according to one of the preceding claims, in which the capacitive modification of the impedance of the said load comprises a connection of a capacitor (CX) to the terminals of the said antenna.

6. Method according to one of the preceding claims, comprising several phases for transmission of information and a monitoring phase prior to each transmission phase.

7. Device for managing the operation of an object capable of contactless communication with a reader magnetically coupled to the said object, comprising first means (205, 203) configured for performing a modulation of the impedance of a load connected across the terminals of the antenna during a phase for transmission of information from the said object to the reader, **characterized in that** it furthermore comprises monitoring means (206) configured for carrying out a monitoring phase, prior to the said transmission phase, comprising a test modulation of the impedance of the said load, a monitoring of the level of amplitude modulation of a modulated test signal present at the antenna of the object and resulting from the said test modulation and a capacitive modification of the impedance of the said load if this level is lower than a threshold (VTH) corresponding to a sensitivity threshold of an amplitude demodulator of the reader.

8. Device according to Claim 7, in which the monitoring means (206) comprise processing means (2001-2004) configured for determining the envelope of this test signal and the amplitude between the peaks and the troughs of this envelope and comparison means (2005) configured for carrying out a comparison of this amplitude with the said threshold.

9. Device according to one of Claims 7 and 8, in which the monitoring means (2003) comprise test means configured for carrying out the said test modulation and comprising a generator (2007) of a test modulation signal (SMT) designed to successively modify the said impedance in such a manner that it alternately takes two different values.

10. Device according to Claim 9, in which the said load comprises a first resistor (R1) connected in parallel across the terminals of the said antenna, and the test means comprise a second resistor (R2) connected in parallel across the terminals of the said antenna via a switch (SW2) controlled by the test modulation signal (SMT), the test modulation signal successively and alternately taking a low level and a high level so as to successively and alternately electrically connect, or otherwise, the said second resistor to the terminals of the antenna.

11. Device according to one of Claims 7 to 10, in which the monitoring means (206) comprise a capacitor (CX) connected to the terminals of the said antenna via an auxiliary switch (SWX) controlled by the output signal (SCM2) of the comparison means (2005).

12. Device according to one of Claims 7 to 11, implemented in an integrated manner.

13. Object comprising a device according to one of Claims 7 to 12.
